# EUROPÄISCHE PATENTSCHRIFT

(11) **EP 1 216 266 B1**
(45) Veröffentlichungstag und Bekanntmachung des Hinweises auf die Patenterteilung: **06.06.2007**
(21) Anmeldenummer: 00963869.3
(22) Anmeldetag: 04.08.2000
(51) Int. Cl.: C08G 59/42, C08G 59/38, C08L 63/04, H01L 33/00

(54) **TRANSPARENTE GIESSHARZMASSE FÜR SMT-FÄHIGE LED-ANWENDUNGEN MIT HOHER TEMPERATUR UND HOHEN HELLIGKEITEN ODER LEUCHTSTÄRKEN**
TRANSPARENT LIQUID RESIN MATERIAL FOR SMT-ENABLED LED-APPLICATIONS AT HIGHER TEMPERATURES AND HIGHER LUMINOSITIES
MATIERE RESINE DE COULEE TRANSPARENTE DESTINEE A DES APPLICATIONS DEL APTES SMT A TEMPERATURE ELEVEE ET FORTES LUMINANCES ET LUMINOSITES

(30) Priorität: 04.08.1999 DE 19936605
(43) Veröffentlichungstag der Anmeldung: 26.06.2002
(73) Patentinhaber: Osram Opto Semiconductors GmbH & Co. OHG, 93049 Regensburg (DE)
(72) Erfinder: HÖHN, Klaus, 82024 Taufkirchen (DE); WAITL, Günter, 93049 Regensburg (DE); ARNDT, Karlheinz, 93059 Regensburg (DE)
(74) Vertreter: Epping - Hermann - Fischer
(86) Internationale Anmeldenummer: PCT/DE2000/002614
(87) Internationale Veröffentlichungsnummer: WO 2001/010926

(56) Entgegenhaltungen:
- DE-A- 3 151 540
- DE-A- 3 241 767
- PATENT ABSTRACTS OF JAPAN vol. 010, no. 355 (C-388), 29. November 1986 (1986-11-29) & JP 61 152723 A (HITACHI CHEM CO LTD), 11. Juli 1986 (1986-07-11)
- PATENT ABSTRACTS OF JAPAN vol. 1997, no. 11, 28. November 1997 (1997-11-28) & JP 09 176282 A (HITACHI CHEM CO LTD), 8. Juli 1997 (1997-07-08)

## Beschreibung

Die Erfindung bezieht sich auf eine transparente Gießharzmasse zum Verguß von optoelektronischen Bauelementen nach dem Oberbegriff des Patentanspruchs 1.

Für den funktionssicheren und zuverlässigen Einsatz mit bis zu 100.000 Betriebsstunden müssen optoelektronische Bauelemente vor widrigen Umgebungseinflüssen geschützt werden. Aufgrund vorteilhafter thermomechanischer wie elektrischer Kennwerte werden vielfach hochreine Epoxidharze in der Elektrotechnik und Elektronik eingesetzt. Epoxidharze weisen eine für Kunststoffe außergewöhnlich hohe chemische Stabilität auf und werden deshalb zur Kapselung von Lumineszenzdioden (LEDs) bei Betriebstemperaturen von derzeit bis 110°C verwendet. Die transparenten und vergilbungsstabilen Duromerwerkstoffe zeigen Glasübergangstemperaturen üblicherweise bis 120°C. Mit zunehmender Leistungs- und Integrationsdichte auf dem Optoelektroniksektor werden crack-resistente, hochbelastbare Verbünde aus Epoxidharzformstoffen mit Glasübergangstemperaturen oberhalb 130°C gefordert. Neben erhöhten Betriebstemperaturen sind für innovative LED-Anwendungen im Automobilbereich die Qualitätsstandards unter verschärften Temperaturzyklen und Temperaturschockbedingungen zu qualifizieren. Die Kapselwerkstoffe müssen in jedem Fall vollständig ausgehärtet sein, um elektrische Degradationen am Bauelement im Betrieb zu vermeiden.

Die in der DE 2642465 beschriebenen Epoxidgießharzformstoffe aus cycloaliphatischen Gießharzabmischungen mit Epoxiden vom Glycidylethertyp weisen zwar hohe Glasübergangstemperaturen >130°C auf, erscheinen allerdings für einen Fertigungseinsatz wegen möglicher zu hoher gesundheitlicher Risiken ungeeignet. Toxikologische Untersuchungen namhafter Institute an diesen Harzabmischungen ergaben in diesem Zusammenhang einen begründeten Verdacht auf ein ausgeprägtes carcinogenes Potential.

SMD-LEDs werden gegenwärtig mit zweikomponentigen, thermischvernetzenden Reaktionsharzen auf Anhydrid-Epoxidgießharzbasis gekapselt. Die optimierten rheologischen und thermisch-reaktiven Eigenschaften der Vergußmasse erlauben rationelle Massenfertigungsprozesse. Die Epoxidharzkomponente besteht aus einem mittelviskosen Bisphenol-A-Diglycidylether mit reaktiven Epoxyverdünner, einem Entschäumergemisch sowie einem Farbstoff-Batch, das wasserklare Formstoffe nach dem Härtungsschritt ermöglicht. Diese A-Komponente kann weiter mit niedermolekularen Alkoholen versetzt sein. Zur Einfärbung werden molekular-dispers verteilbare Farbstoffe herangezogen. Diffus licht-emittierende Bauelemente werden durch die Zugabe spezieller Diffusorpasten auf Basis anorganischer Pigmente herangezogen. Unterschiedliche Zinksalz-beschleunigte Anhydride modifiziert mit saurem Ester unter Zugabe von Oxidationsstabilisatoren bilden die Härterkomponente. Mit der vorliegenden Vergußmasse können die steigenden Qualitätsmerkmale künftiger LED-Generationen hinsichtlich Temperatureinsatzbereich und Temperaturwechselbeständigkeit nach Automobilstandards jedoch nicht hinreichend erfüllt werden.

Es ist daher Aufgabe der vorliegenden Erfindung, eine Gießharzmasse anzugeben, die einen größeren Temperatureinsatzbereich, insbesondere eine höhere Glasübergangstemperatur, und dabei gleichzeitig niedrige gesundheitliche Risiken aufweist.

Weiterhin sollten die damit hergestellten Produkte in allen gängigen Lötverfahren zu verwenden sein und kurze Härtungszyklen für Massenfertigungsprozesse gewährleisten. Für Lumineszenzdioden mit hohen Leuchtstärken werden transparente, thermisch wie photochemisch farbstabile Formstoffe gefordert.

Diese Aufgabe wird mit den Merkmalen des Patentanspruchs 1 gelöst. Demnach beschreibt die Erfindung eine transparente Gießharzmasse als Kapsel- und Montagewerkstoff zum Verguß von optoelektronischen Bauelementen auf der Basis einer säureanhydridhärtbaren Epoxidverbindung, die hergestellt ist durch Mischung aus einer A-Komponente, bestehend aus mindestens einer Epoxidverbindung, und mindestens einem mehrfachfunktionellen Epoxynovolakharz, und gegebenenfalls weiteren Zusatzstoffen, und einer B-Komponente, bestehend aus mindestens einem Carbonsäureanhydrid.

Die erfindungsgemäßen transparenten Epoxidgießharzformulierungen sind vorteilhafterweise in etablierter Packaging-Technologie zu verarbeiten und entsprechen den optischen, elektrischen und thermomechanischen Qualitätsansprüchen künftiger Produktgenerationen in der Optoelektronik und weisen vor allem Glasübergangstemperaturen oberhalb 130°C auf. Das toxische Gefährdungspotential der Ausgangsmaterialien ist nach heutigem Erkenntnisstand gering, so daß gesundheitliche Risiken möglichst ausgeschlossen werden können.

Systematische Grundlagenuntersuchungen zur Entwicklung stressarmer Kunststoffverbünde in der Elektronik ergaben, daß die Glasübergangstemperaturen anhydridisch härtbarer Epoxidharzformstoffe auf Bisphenol-A-Epoxidharzbasis durch die Zugabe multifunktioneller Epoxynovolakharze deutlich erhöht werden konnten. Weiterhin wurde beobachtet, daß derartige Novolakstrukturen zur Schwundreduzierung bei der Verarbeitung beitragen und die mechanischen Eigenschaften verbessern. Die linear bruchelastischen K_{IC}- und G_{IC}-Werte konnten ebenfalls gesteigert werden. Die weiterhin günstigen Haftungswerte der hochfesten Duromerwerkstoffe im Zugscherversuch (DIN 53283) waren günstige Voraussetzungen für den Einsatz von Epoxynovolakharzen in der Optoelektronik, weil auch gefunden wurde, daß damit temperatur- und vergilbungsstabile Reaktionsharzformstoffe herstellbar waren. Da Epoxynovolakharze hochviskos bzw. fest sind, mußten die rheologischen Eigenschaften entsprechender Formulierungen den Erfordernissen in der Gießharztechnologie angepaßt werden. Daneben war es auch erforderlich, das reaktive Verhalten hinsichtlich Fertigungstauglichkeit und geforderter Glasübergangstemperatur anzupassen.

Vorzugsweise weist die A-Komponente noch weitere Zusatzstoffe wie einen Reaktivverdünner, ein Alkohol, einen Haftvermittler, ein Verlaufshilfsmittel, ein Agens zum Entgasen, eine Diffusorpaste, und eine Komponente zur Einstellung der Farbzahl/Einfärbung auf.

Eine erfindungsgemäße Epoxidgießharzkomponente setzt sich dementsprechend vorzugsweise wie folgt zusammen:

| | |
|---|---|
| mehrfunktionelle Epoxidgießharze: (Bisphenol-A-Diglycidylether) | < 80 Gew.-% |
| Epoxykresolnovolak: | < 50 Gew.-% |
| Reaktivverdünner: (Monoglycidylether) | < 10 Gew.-% |
| Alkohol: | < 10 Gew.-% |
| Diffusorpaste (Pigment in Epoxid-gießharz) | < 10 Gew.-% |
| Haftvermittler: | < 5 Gew.-% |
| Verlaufshilfsmittel: (Silikonbasis) | < 1 Gew.-% |
| Agens zum Entgasen: (Silikonbasis) | < 1 Gew.-% |
| Komponente zur Einstellung der Farbzahl/Einfärbung: (Farbstoff in Epoxidgießharz) | < 1 Gew.-% |
| internes Trennmittel abhängig vom Gehäusetyp: (Silikonbasis) | < Gew.-% |

Das Carbonsäureanhydrid kann beispielsweise - wie in der DE 26 42 465 ein Hexahydrophthalsäureanhydrid sein.

Die Glasübergangstemperaturen eines Formstoffes aus dem vorgenannten Ausführungsbeispiel mit einem Mischungsverhältnis A:B von 100:90 beträgt 140°C. Unter Fertigungsbedingungen wurden am Bauelement 135°C erhalten. Alle funktions- und bauelementespezifischen Qualifizierungen nach aktuellsten Standards der Automobilelektronik wurden bestanden.

Im folgenden wird ein konkretes Ausführungsbeispiel für die A-Komponente angegeben:

| | |
|---|---|
| D.E.R. 332 (Dow Chemical): | 78,96 |
| (Bisphenol-A-Diglycidylether) | Gew.-% |
| D.E.N. 438 (Dow Chemical): | 20,00 |
| (Epoxy Novolak) | Gew.-% |
| BYK-A506 (BYK Chemie GmbH): | 0,20 |
| (Agens zum Entgasen) | Gew.-% |
| Silane A187 (OSi Specialities): | 0,80 |
| (Haftvermittler) | Gew.-% |
| Masterbatch 09 (CIBA Specialities): | 0,04 |
| (Einstellung der Farbe) | Gew.-% |

Dieses Ausführungsbeispiel zeigt die folgenden technischen Kenndaten und Formstoffeigenschaften:

| | |
|---|---|
| Viskosität der A:B-Mischung: (Platte-Kegel, 25°C, D=500 1/s) | 1250 mPas |
| Gebrauchsdauer bei 30°C | 8 h |
| Glasübergangstemperatur (DSC, 10 K/min) | 135±5°C |
| Härte Shore D | 86-88 |
| Wasseraufnahme: (2 Wochen Wasserlagerung | < 0,5 |
| bei 23°C) | Gew.-% |
| Biegemodul (DIN53452) | 2750 MPa |
| Biegefestigkeit (DIN53452) | 150 MPa |
| Biegung am Bruch (DIN 53452) | 7,2 % |
| Transmission bei 500 nm: (1 mm Formstoffdicke) | > 88 % |
| Farbabstand nach Formstoffalterung: (6 Wochen 120°C) | 4,6 |
| Masseverlust bis 300°C: (TG/DTA, 10K/min, Stickstoff) | < 2 % |

Weitere typische Parameter, Eigenschaften und Einstellungen der vorgenannten Produkte und Vorprodukte sind:

Die Viskosität der Epoxidhärzkomponente bei 25°C ist < 15.000 mPas.

Die Viskosität der A:B-Reaktionsharzmischung bei 25°C ist < 3.000 mPas.

Die Lagerfähigkeit der Epoxidgießharzkomponente beträgt bei Temperaturen bis 30°C mindestens 1 Jahr.

Die Gebrauchsdauer der A:B-Reaktionsharzmischung bei 25°C beträgt mindestens 6 h.

Das günstige reaktive Verhalten der A:B-Reaktionsharzmischung erlaubt schnelle Härtungszyklen bei zuverlässigem Bauelementeverguß in Massenfertigungsprozessen mit Stückzahlen von mehreren 100 Mio. pro Jahr.

Die Glasübergangstemperatur der Formstoffe ist > 130°C.
Die Wasseraufnahme nach 2 Wochen Wasserlagerung bei 23 °C ist < 0,5 Gew.-%

Die Transmission eines 1 mm dicken Formstoffes im sichtbaren Bereich des Lichts beträgt > 88 %.

Die Farbverschiebung nach thermischer Alterung 130°C nach 6 Wochen ist < 10.

Die damit hergestellten Linsen erweisen sich in leuchtstarken LEDs mit beispielsweise 1,4 lm/50 mA als strahlenbeständig.

Die vorliegende Formstoffentwicklung zeichnet sich durch außergewöhnliche bruchmechanische Eigenschaften aus, mit K_{IC} 1,34 MPa√m und G_{IC} 577 J/m²; die damit gekapselten Produkte sind in allen SMT-Prozessen einsetzbar und eignen sich darüber hinaus für Anwendungen im Automobilbereich (Tg > 130 °C!)

Der Masseabbau bis 300°C ist < 2 % (Thermowaage, 10 K/min, Stickstoff).

## Patentansprüche

1. Transparente Gießharzmasse zum Verguß von optoelektronischen Bauelementen auf der Basis einer säureanhydridhärtbaren Epoxidverbindung,
- hergestellt durch Mischung aus einer A-Komponente, einer B-Komponente und gegebenenfalls weiterer Zusatzstoffe, im Verhältnis von 100:100 bis 100:80
- mit einer Viskosität der A:B-Reaktionsharzmischung bei 25°C von weniger als 3000 mPas
- mit einer Glasübergangstemperatur des daraus hergestellten Formstoffs größer 130°C
wobei die A-Komponente als einzige Epoxy-Komponenten enthält:
- eine Diglycidylether von Bisphenol-A umfassende Epoxidverbindung mit der Maßgabe, daß cycloaliphatische Epoxidverbindungen ausgeschlossen sind
- ein Epoxynovolakharz als mehrfachfunktionelles Epoxid mit einem Anteil vom 20 bis < 50 Gew.% in der A-Komponente, und
- gegebenenfalls einen Monoglycidylether als Reaktivverdünner mit einem Anteil < 10 Gew%,
wobei die B-Komponente einen Zinksalzbeschleuniger umfaßt und als Säureanhydrid zumindest ein Carbonsäureanhydrid enthält.

2. Gießharzmasse nach Anspruch 1,
bei der das Epoxynovolakharz Epoxykresolnovolak ist.

3. Gießharzmasse nach Anspruch 1 oder 2,
bei der die A-Komponente die folgende prozentuale Zusammensetzung aufweist:
- Epoxidverbindung: < 80 Gew.-%
- Epoxynovolakharz: 20-50 Gew.-%
- Reaktivverdünner: < 10 Gew.-%
- Alkohol: < 10 Gew.-%
- Diffusorpaste: < 10 Gew.-%
- Haftvermittler: < 5 Gew.-%
- Verlaufshilfsmittel: < 1 Gew.-%
- Agens zum Entgasen: < 1 Gew.-%
- Farbstoff in Epoxidgießharz: < 1 Gew.-%
- internes Trennmittel
abhängig vom Gehäusetyp: < 1 Gew.-%

4. Gießharzmasse nach einem der Ansprüche 1 bis 3,
bei der die A-Komponente die folgende prozentuale Zusammensetzung aufweist:
- Bisphenol-A-Diglycidylether 78,96 Gew.-%
- Epoxy Novolak 20,00 Gew.-%
- Agens zum Entgasen 0,20 Gew.-%
- Haftvermittler 0,80 Gew.-%
- Einstellung der Farbe 0,04 Gew.-%

5. Gießharzmasse nach einem der Ansprüche 1 bis 4,
bei der die B-Komponente derart beschaffen ist, daß die spezifische Beschleunigung Härtungszyklen für Massenfertigungsprozesse im Minutenbereich erlaubt.

6. Gießharzmasse nach einem der Ansprüche 1 bis 5,
bei der die B-Komponente 2 bis 10 Gew.-% Metallsalzbeschleuniger enthält.

7. Gießharzmasse nach einem der Ansprüche 1 bis 6,
bei der die B-Komponente 2 bis 10 Gew.-% Zinksalzbeschleuniger enthält.

8. Verwendung der Gießharzmasse nach einem der vorhergehenden Ansprüche als Montage- und Kapselwerkstoff zum Vergießen, Abdecken oder Umhüllen von elektronischen und optoelektronischen Bauelementen, Modulen und Komponenten.

9. Verwendung der Gießharzmasse nach Anspruch 8 zum Abdek-ken oder Umhüllen von Lumineszenzdioden, Phototransistoren, Photodioden und Lumineszenzdioden-Displays.

10. Verwendung der Gießharzmasse nach Anspruch 8 als Lichtleitharz für optoelektronische Koppler.

## Claims

1. Transparent casting resin compound for encapsulating optoelectronic devices, based on an acid anhydride-curable epoxide compound
- prepared by mixing an A component, a B component and, if desired, further additives, in a ratio of 100:100 to 100:80
- with a viscosity of the A:B reactive resin mixture at 25°C of less than 3000 mPas
- with a glass transition temperature of the moulding material produced therefrom of greater than 130°C,
the A component comprising as sole epoxy components:
- an epoxide compound comprising diglycidyl ether of bisphenol A, with the proviso that cycloaliphatic epoxide compounds are excluded,
- an epoxy novolak resin as a polyfunctional epoxide, with a fraction of 20% to < 50% by weight in the A component, and
- if desired, a monoglycidyl ether as reactive diluent, with a fraction < 10% by weight,
the B component comprising a zinc salt accelerator and comprising as acid anhydride at least one carboxylic anhydride.

2. Casting resin compound according to Claim 1, wherein the epoxy novolak resin is epoxy cresol novolak.

3. Casting resin compound according to Claim 1 or 2, wherein the A component has the following percentage composition:
- epoxide compound: < 80% by weight
- epoxy novolak resin: 20-50% by weight
- reactive diluent: < 10% by weight
- alcohol: < 10% by weight
- diffusion paste: < 10% by weight
- adhesion promoter: < 5% by weight
- flow control assistant: < 1% by weight
- degassing agent: < 1% by weight
- dye in epoxy casting resin: < 1% by weight
- internal release agent,
dependent on case type: < 1% by weight

4. Casting resin compound according to one of Claims 1 to 3, wherein the A component has the following percentage composition:
- bisphenol A diglycidyl ether 78.96% by weight
- epoxy novolak 20.00% by weight
- degassing agent 0.20% by weight
- adhesion promoter 0.80% by weight
- colour modifier 0.04% by weight

5. Casting resin compound according to one of Claims 1 to 4, wherein the B component is such that the specific acceleration permits curing cycles in the minutes range for mass fabrication processes.

6. Casting resin compound according to one of Claims 1 to 5, wherein the B component contains 2% to 10% by weight of metal salt accelerator.

7. Casting resin compound according to one of Claims 1 to 6, wherein the B component contains 2% to 10% by weight of zinc salt accelerator.

8. Use of the casting resin compound according to one of the preceding claims as assembly material and package material for encapsulating, covering or encasing electronic and optoelectronic devices, modules and components.

9. Use of the casting resin compound according to Claim 8 for covering or encasing light-emitting diodes, phototransistors, photodiodes and light-emitting diode displays.

10. Use of the casting resin compound according to Claim 8, as photoconductive resin for optoelectronic couplers.

## Revendications

1. Composition transparente de résine de coulée pour le scellement de composants optoélectroniques, à base d'un composé époxyde pouvant être durci par un anhydride d'acide,
- préparée par mélange d'un constituant A, d'un constituant B et, le cas échéant, d'autres additifs dans le rapport de 100 : 100 à 100 : 80,
- ayant une viscosité du mélange de résine réactionnelle A : B à 25° C inférieur à 3000 mPas,
- ayant un point de transition à l'état vitreux de la matière moulée ainsi préparée supérieur à 130°C,
dans laquelle le constituant A contient comme unique constituant époxy :
- un composé époxyde comprenant de l'éther diglycidylique du bisphénol A à la condition que des composés époxydes cycloaliphatiques soient exclus,
- une résine époxy novolaque en tant qu'époxyde multifonctionnelle en une proportion de 20 à < 50 % en poids dans le constituant A, et
- le cas échéant un éther monoglycidylique en tant que diluant réactif en une proportion < 10 % en poids,
le constituant B comprenant un accélérateur au sel de zinc et comme anhydride d'acide au moins un anhydride d'acide carboxylique.

2. Composition de résine de coulée suivant la revendication 1,
dans laquelle la résine époxy novolaque est une époxy résolnovolak.

3. Composition de résine de coulée suivant la revendication 1 ou 2,
dans laquelle le constituant A comporte la composition suivante en % :
- composé époxyde < 80 % en poids
- résine époxy novolaque 20 à 50 % en poids
- diluant réactif < 10 % en poids
- alcool < 10 % en poids
- pâte de diffuseur < 10 % en poids
- agent adhésif < 5 % en poids
- adjuvant d'écoulement < 1 % en poids
- agent de dégazage < 1 % en poids
- colorant dans la résine de
coulée époxyde < 1 % en poids
- agent de séparation interne
en fonction du type de boîtier < 1 % en poids

4. Composition de résine de coulée suivant l'une des revendications 1 à 3,
dans laquelle le constituant A a la composition suivante en %
- éther diglycidylique du bisphénol A 78,96 % en poids
- époxy novolaque 20,00 % en poids
- agent de dégazage 0,20 % en poids
- agent adhésif 0,80 % en poids
- réglage de la couleur 0,04 % en poids

5. Composition de résine de coulée suivant l'une des revendications 1 à 4,
dans laquelle le constituant B est tel que l'accélération spécifique permet d'avoir des cycles de durcissement pour des processus de fabrication en masse de l'ordre de la minute.

6. Composition de résine de coulée suivant l'une des revendications 1 à 5,
dans laquelle le constituant B contient de 2 à 10 % en poids d'un sel métallique servant d'accélérateur.

7. Composition de résine de coulée suivant l'une des revendications 1 à 6,
dans laquelle le constituant B contient de 2 à 10 % en poids de sel de zinc servant d'accélérateur.

8. Utilisation de la composition de résine de coulée suivant l'une des revendications précédentes, comme matériau de montage ou d'encapsulage pour le scellement, le recouvrement ou l'enrobage de composants, modules et constituants électroniques et optoélectroniques.

9. Utilisation de la composition de résine de coulée suivant la revendication 8, pour recouvrir ou enrober des diodes luminescentes, des phototransistors, des photodiodes et des dispositifs d'affichage à diodes luminescentes.

10. Utilisation de la composition de résine de coulée suivant la revendication 8, comme résine conductrice de la lumière pour des coupleurs optoélectroniques.
